# FASCICULE DE BREVET EUROPEEN

(11) **EP 0 648 013 B1**
(45) Date de publication et mention de la délivrance du brevet: **30.12.1998**
(21) Numéro de dépôt: 94402236.7
(22) Date de dépôt: 05.10.1994
(51) Int. Cl.: H03H 7/48

(54) **Dispositif pour distribuer des signaux analogiques rapides à plusieurs utilisateurs**
Vorrichtung zum Verteilen von schnellen analogen Signalen auf mehrere Benutzer
Means for distributing fast analog signals to plural users

(30) Priorité: 07.10.1993 FR 9311957
(43) Date de publication de la demande: 12.04.1995
(73) Titulaire: COMPAGNIE D'ETUDES, DE REALISATIONS ET D'INSTALLATIONS DE SYSTEMES (CORIS), 92350 Le Plessis Robinson (FR)
(72) Inventeur: Mattenet, Jean-Claude, F-91460 Marcoussis (FR); Danion, Christian, F-78960 Voisin Le Bretonneux (FR); Even, Daniel, F-78200 Mantes La Jolie (FR)
(74) Mandataire: Chameroy, Claude

(56) Documents cités:
- EP-A- 0 430 727
- US-A- 4 502 026
- US-A- 4 907 231

## Description

La présente invention concerne un dispositif pour distribuer des signaux analogiques rapides à plusieurs utilisateurs.

Il convient tout d'abord de noter que cette notion de rapidité des signaux analogiques est déterminée par la répartition spectrale en fréquence du signal considéré, généralement comprise entre 0 et 60 Mhz. Il peut s'agir par exemple des signaux vidéo issus de caméras ou de synthétiseurs d'images, et plus généralement des signaux Hautes Fréquences (HF) issus par exemple d'antennes de réception. Ces familles de signaux présentent la particularité d'être habituellement véhiculés sur des supports adaptés en impédance, typiquement 50 ou 75 Ohms.

Jusqu'à maintenant, pour distribuer de tels signaux à plusieurs utilisateurs, on utilise le plus souvent des multicoupleurs associés à des relais coaxiaux en forme de matrice, ce qui conduit à un encombrement important et à un coût élevé.

La présente invention a donc pour but principal de remédier à ces inconvénients et, pour ce faire, elle a pour objet un dispositif du type susmentionné qui se caractérise essentiellement en ce qu'il comprend :
- une carte de type fond de panier sur laquelle est imprimée, sous forme de piste, au moins une ligne de distribution bifilaire dont une extrémité est alimentée par une source du signal à distribuer et dont l'autre extrémité est refermée sur une impédance de charge égale à l'impédance caractéristique de la ligne ;
- des embases de connexion pour cartes imprimées, fixées sur la carte fond de panier et réparties le long de la ligne de distribution ; et
- des cartes imprimées utilisateurs dotées chacune d'un connecteur apte à s'enficher dans l'une des embases de la carte imprimée fond de panier, chacune de ces cartes utilisateurs comportant un amplificateur dont l'entrée à haute impédance est reliée à la ligne de distribution par l'intermédiaire de son connecteur et de l'embase correspondante et dont la sortie à basse impédance est reliée à une borne de connexion pour un utilisateur.

Grâce à cet ensemble de dispositions et ainsi qu'on le verra plus clairement par la suite, il est possible de réaliser un matériel compact à un prix inférieur à la solution traditionnelle, sans sacrifier les performances.

De préférence, l'entrée à haute impédance de l'amplificateur est reliée à la ligne de distribution par une piste imprimée courte, afin d'éviter dans la mesure du possible une désadaptation d'impédance nuisible à la qualité du signal.

De préférence également, la sortie à basse impédance de l'amplificateur est adaptée sur l'impédance de la source de signal.

Ainsi, tout se passe comme si l'utilisateur final était branché directement sur la source de signal.

En variante, la ligne de distribution est pourvue en tête de ligne d'un dispositif de modification d'impédance et se referme à son autre extrémité sur une impédance égale à l'impédance ramenée par ledit dispositif de modification d'impédance.

Ceci permet dans certains cas d'abaisser l'impédance caractéristique de la ligne afin de se prémunir contre un parasitage des signaux dû à l'environnement ou une charge capacitive trop importante ramenée par les cartes utilisateurs.

Dans une forme de réalisation particulière de l'invention, dans laquelle la carte imprimée fond de panier comporte plusieurs lignes de distribution alimentées chacune par un signal déterminé à distribuer, chaque carte imprimée utilisateur est équipée d'un organe de commutation à plusieurs voies interposé entre le connecteur et l'amplificateur à haute impédance d'entrée.

De préférence, l'organe de commutation est constitué par un relais non coaxial du type relais standard par exemple.

En effet, la présente invention permet d'utiliser des relais ordinaires du commerce à faible coût et faible volume, à la place des relais coaxiaux qui étaient jusqu'à présent nécessaires.

En variante, un organe de surveillance et de comparaison est inséré dans le circuit de commande du relais, pour comparer une information relative à l'état réel de la bobine d'excitation du relais et une information relative à l'état présumé de cette bobine, et générer une alarme en cas de disparité entre ces deux informations.

Dans le cas où le nombre d'utilisateurs susceptibles de se connecter sur une même ligne est élevé, des quadripôles non dissipatifs sont insérés sur chaque ligne de distribution entre les embases de connexion.

Grâce à de tels quadripôles, convenablement calculés, il est possible de minimiser l'effet des capacités parasites ramenées sur la ligne par les cartes utilisateurs et donc d'éviter une dégradation de la réponse spectrale du dispositif.

Plusieurs formes d'exécution de l'invention sont décrites ci-après à titre d'exemples, en référence aux dessins annexés dans lesquels :
- la figure 1 est un schéma synoptique d'un dispositif de distribution de signaux analogiques conforme à l'invention ;
- la figure 2 est une vue simplifiée en perspective d'un mode de réalisation pratique de ce dispositif ; et
- la figure 3 est un schéma synoptique partiel d'une variante de réalisation de l'invention.

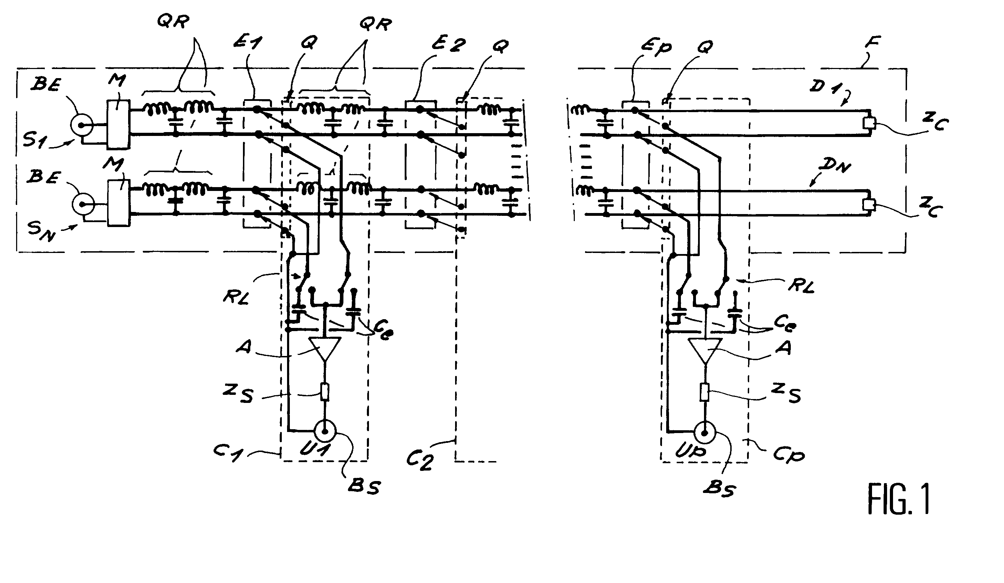

Le dispositif représenté sur la figure 1 comprend tout d'abord une carte imprimée F du type "fond de panier". Sur cette carte F sont réalisées, sous la forme de pistes imprimées, un certain nombre de lignes de distribution bifilaires D₁ à D_{N} disposées en parallèle. Chacune de ces lignes de distribution D₁ à D_{N} est reliée à une extrémité à une source de signal à distribuer, respectivement S₁ à S_{N}, par l'intermédiaire d'une borne d'entrée B_{E}, les différents signaux à distribuer étant constitués ici par des signaux analogiques rapides tels que des signaux vidéo par exemple.

A l'autre extrémité, chacune des lignes est refermée sur une impédance Z_{C} égale à l'impédance caractéristique de la ligne, typiquement 50 ou 75 Ohms, cette impédance étant par ailleurs égale à l'impédance de la source de signal. Le cas échéant, cette impédance de source peut être modifiée, et notamment abaissée, par l'adjonction en tête de ligne d'un dispositif de modification d'impédance M constitué par exemple par un transformateur, cette disposition permettant de se prémunir contre un parasitage des signaux dû à l'environnement et contre une charge capacitive importante ramenée par les cartes utilisateurs. Dans ce cas évidemment, l'impédance caractéristique de la ligne et l'impédance de charge Z_{C} devront être égales à l'impédance ramenée par le dispositif de modification d'impédance M.

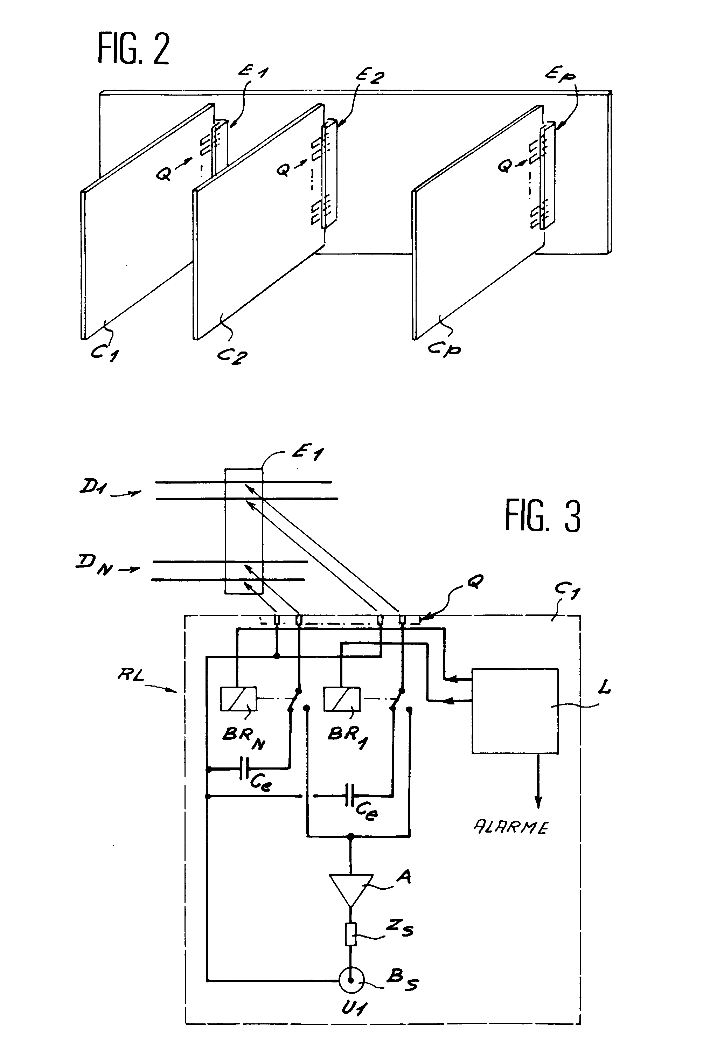

Afin de pouvoir collecter les différents signaux distribués sur les lignes D₁ à D_{N}, la carte fond de panier F est équipée d'un certain nombre d'embases E₁ à E_{P} pour la connexion de cartes imprimées utilisateurs C₁ à C_{P} munies chacune d'un connecteur approprié Q apte à s'enficher dans l'une quelconque desdites embases. Ces embases sont fixées sur la carte F et réparties le long des lignes D₁ à D_{N}, de sorte que le dispositif de distribution de signaux se présente alors physiquement sous la forme représentée sur la figure 2, avec les cartes utilisateurs C₁ à C_{P} disposées en parallèle, perpendiculairement à la carte fond panier.

Conformément à l'invention, chacune des cartes imprimées utilisateurs C₁ à C_{P} comporte tout d'abord un amplificateur à haute impédance d'entrée A, par exemple un amplificateur trans-impédance, dont l'entrée peut être reliée de manière sélective aux différentes lignes de distribution D₁ à D_{N} par l'intermédiaire d'un système de relais à plusieurs voies RL ou de tout autre organe de commutation approprié, et dont la sortie est reliée à un utilisateur U₁...U_{P} par l'intermédiaire d'une borne de sortie B_{S}.

L'utilisation d'un tel amplificateur à haute impédance d'entrée permet de garantir une atténuation en tension du signal distribué extrêmement faible. De ce fait, la mise en parallèle de plusieurs cartes utilisateurs C₁ à C_{P} sur un même signal distribué par l'une des lignes D₁ à D_{N} de la carte fond de panier F ne produit que des variations de niveau négligeables.

Par ailleurs, l'entrée à haute impédance de l'amplificateur A est reliée au connecteur correspondant Q de la carte par une piste imprimée courte. En effet, un tel amplificateur induit une désadaptation d'impédance nuisible à la qualité du signal, qui est d'autant plus perceptible que cette piste imprimée de liaison est longue.

Cependant, si par le nombre d'utilisateurs susceptibles de se connecter sur une même ligne, la charge capacitive sur la ligne, due aux capacités parasites inhérentes à tout montage, devenait trop importante et dégradait la réponse spectrale du dispositif, il est prévu d'insérer sur chaque ligne D₁...D_{N}, entre les embases E₁...E_{P}, des quadripôles QR non dissipatifs du type à inductance série et capacitance parallèle, comme représenté sur la figure 1. Tous ces quadripôles sont identiques et constituent une ligne à retard refermée sur son impédance caractéristique. Dans ce cas toutefois, l'impédance de charge Z_{C} terminant la ligne est de nature complexe et sera réalisée par l'association d'éléments réactifs et de résistances, par exemple une inductance en série avec une résistance. De plus, on utilisera, dans certains cas, un dispositif abaisseur d'impédance M en tête de ligne, afin d'augmenter l'efficacité des quadripôles QR vis-à-vis de la charge capacitive indésirable.

Bien entendu, tous ces quadripôles QR, ainsi d'ailleurs que l'impédance de charge Z_{C}, pourront le cas échéant être réalisés directement sur la carte imprimée fond de panier F en créant des motifs géométriques possédant les self-inductances, capacitances et résistances nécessaires, convenablement calculées.

Cependant les capacités parasites des relais RL et des amplificateurs A vont s'additionner aux capacités fixes des quadripôles QR. De plus, la capacité parasite totale ramenée sur la capacité d'un quadripôle QR dépend de l'état commuté ou non du relais RL sur la ligne de distribution considérée. En effet, sur une ligne de distribution, la capacité parasite ramenée par la carte utilisateur est faible si RL est non commuté et plus importante si RL est commuté.

Ce phénomène ne permet donc pas une compensation efficace par les quadripôles QR dont les caractéristiques vont fluctuer selon les valeurs des capacités parasites.

Afin de remédier à ce problème, les relais RL sont choisis dotés d'un contact Repos/Travail. Le contact Travail sert à effectuer la commutation proprement dite et le contact Repos permet de connecter au circuit une capacité Cₑ équivalente à la capacité parasite en état commuté. Ceci permet à la ligne de distribution de voir une capacité constante, à savoir :
- dans le cas commuté, la capacité parasite totale ; et
- dans le cas non commuté, une capacité réelle Cₑ, image de la capacité parasite.

Il devient donc possible d'insérer des quadripôles QR dont le fonctionnement ne dépend plus de l'état commuté ou non de la carte utilisateur.

Il faut noter que dans certains cas cette valeur de capacité est suffisante pour l'efficacité du quadripôle QR et permet de ne pas monter des capacités sur la carte fond de panier F qui supporte les quadripôles QR.

Enfin, l'amplificateur A devra également être à basse impédance de sortie, afin de reproduire à l'utilisateur final l'impédance de la source de signal. A cet effet, sa sortie pourra être adaptée sur l'impédance de source au moyen par exemple d'une impédance Z_{S}. Le cas échéant, cet amplificateur aura en outre un facteur d'amplification compensant le facteur d'amplification du dispositif de modification d'impédance M.

On dispose ainsi d'un véritable bus HF permettant de connecter de manière sélective P utilisateurs à N sources de signaux analogiques rapides. De plus, grâce à la séparation de la fonction distribution, matérialisée par la carte fond de panier F, et de la fonction utilisation, matérialisée par les cartes imprimées C₁ à C_{P}, il est possible de réaliser ce bus sous une forme très compacte, tout en conservant de bonnes performances. On notera enfin qu'un tel bus peut également être réalisé de manière peu coûteuse, grâce notamment au fait qu'il permet d'utiliser comme organe de commutation des relais ordinaires non coaxiaux.

Dans la variante de réalisation représentée sur la figure 3, un module logique L de surveillance et de comparaison est inséré dans le circuit de commande des bobines BR₁...BR_{N} de chaque relais RL, ce qui permet de surveiller le courant d'excitation de la bobine et de vérifier que celle-ci est effectivement pilotée, afin de réaliser une commutation sécurisée. Ce module génère en effet une information relative à l'état réel de la bobine qui est ensuite comparée avec une information relative de l'état présumé de ladite bobine, une alarme étant engendrée en cas de disparité entre ces deux informations.

On dispose ainsi d'un accès sécurisé au bus de signaux analogiques rapides conforme à l'invention.

## Revendications

1. Dispositif pour distribuer des signaux analogiques rapides à plusieurs utilisateurs, caractérisé en ce qu'il comprend :
- une carte de type fond de panier (F) sur laquelle est imprimée, sous forme de piste, au moins une ligne de distribution bifilaire (D₁...D_{N}) dont une extrémité est alimentée par une source (S₁...S_{N}) du signal à distribuer et dont l'autre extrémité est refermée sur une impédance de charge (Z_{C}) égale à l'impédance caractéristique de la ligne ;
- des embases de connexion (E₁...E_{P}) pour cartes imprimées, fixées sur la carte fond de panier (F) et réparties le long de la ligne de distribution (D₁...D_{N}) ; et
- des cartes imprimées utilisateurs (C₁...C_{P}) dotées chacune d'un connecteur (Q) apte à s'enficher dans l'une des embases (E₁...E_{P}) de la carte imprimée fond de panier (F), chacune de ces cartes utilisateurs (C₁...C_{P}) comportant un amplificateur (A) dont l'entrée à haute impédance est reliée à la ligne de distribution (D₁...D_{N}) par l'intermédiaire de son connecteur (Q) et de l'embase correspondante (E₁...E_{P}) et dont la sortie à basse impédance est reliée à une borne de connexion (B_{S}) pour un utilisateur (U₁...U_{P}).

2. Dispositif selon la revendication 1, caractérisé en ce que l'entrée à haute impédance de l'amplificateur (A) est reliée à la ligne de distribution (D₁...D_{N}) par une piste imprimée courte.

3. Dispositif selon la revendication 1 ou 2, caractérisé en ce que la sortie à basse impédance de l'amplificateur (A) est adaptée sur l'impédance (Z_{S}) de la source de signal (S₁...S_{N}).

4. Dispositif selon l'une quelconque des revendications 1 à 3, caractérisé en ce que la ligne de distribution (D₁...D_{N}) est pourvue en tête de ligne d'un dispositif de modification d'impédance (M) et se referme à son autre extrémité sur une impédance de charge (Z_{C}) égale à l'impédance ramenée par ledit dispositif de modification d'impédance (M).

5. Dispositif selon l'une quelconque des revendications 1 à 4, dans lequel la carte imprimée fond de panier (F) comporte plusieurs lignes de distribution (D₁...D_{N}) alimentées chacune par un signal déterminé (S₁...S_{N}) à distribuer, caractérisé en ce que chaque carte imprimée (C₁...C_{P}) est équipée d'un organe de commutation à plusieurs voies (RL) interposé entre le connecteur (Q) et l'amplificateur à haute impédance d'entrée (A).

6. Dispositif selon la revendication 5, caractérisé en ce que l'organe de commutation (RL) est constitué par un relais standard non coaxial.

7. Dispositif selon la revendication 6, caractérisé en ce qu'un organe de surveillance et de comparaison (L) est inséré dans le circuit de commande du relais (RL), pour comparer une information relative à l'état réel de la bobine d'excitation (BR₁...BR_{N}) du relais (RL) et une information relative à l'état présumé de cette bobine, et générer une alarme en cas de disparité entre ces deux informations.

8. Dispositif selon l'une quelconque des revendications 1 à 7, caractérisé en ce que des quadripôles non dissipatifs (QR) sont insérés sur chaque ligne de distribution (D₁...D_{N}), entre les embases de connexion (E₁...E_{P}).

9. Dispositif selon la revendication 8, caractérisé en ce que les quadripôles (QR) sont du type à inductance série et capacitance parallèle.

10. Dispositif selon la revendication 8 ou 9, caractérisé en ce que l'impédance de charge (Z_{C}) est constituée par une inductance en série avec une résistance.

11. Dispositif selon la revendication 6 ou 7 et l'une quelconque des revendications 8 à 10, caractérisé en ce que chacun des relais est doté d'un contact Repos/Travail, le contact Repos permettant de connecter au circuit une capacité (Cₑ) équivalente à la capacité parasite totale de l'amplificateur correspondant (A) et du relais correspondant (RL) commuté sur son contact Travail.

## Patentansprüche

1. Vorrichtung zum Verteilen von schnellen analogen Signalen an mehrere Benutzer,
**dadurch gekennzeichnet**, daß sie umfaßt:
- eine Platine (F) des Typs Träger-Leiterplatte, auf die bahnförmig wenigstens eine zweiadrige Verteilerleitung (D₁...D_{N}) gedruckt ist, an deren einem Ende eine Quelle (S₁...S_{N}) das zu verteilende Signal einspeist und deren anderes Ende über eine Belastungsimpedanz (Z_{C}) gleich der Kennimpedanz der Leitung geschlossen ist;
- Anschlußsockel (E₁...Eₚ) für Leiterplatten, befestigt auf der Träger-Leiterplatte (F) und längs der Verteilerleitung (D₁...D_{N}) verteilt; und
- Benutzer-Leiterplatten (C₁...Cₚ), jede versehen mit einem Steckverbinder (Q), der in einen der Sockel (E₁...Eₚ) der Träger-Leiterplatte (F) gesteckt werden kann, wobei jede dieser Benutzer-Leiterplatten (C₁...Cₚ) einen Verstärker (A) umfaßt, dessen hochohmiger Eingang über ihren Steckverbinder (Q) und den entsprechenden Sockel (E₁...Eₚ) mit der Verteilerleitung (D₁...D_{N}) verbunden ist, und deren niederohmiger Ausgang mit einer Anschlußklemme (B_{S}) für einen Benutzer (U₁...Uₚ) verbunden ist.

2. Vorrichtung nach Anspruch 1, dadurch gekennzeichnet, daß der hochohmige Eingang des Verstärkers (A) mit der Verteilerleitung (D₁...D_{N}) durch eine kurze gedruckte Leiterbahn verbunden ist.

3. Vorrichtung nach Anspruch 1 oder 2, dadurch gekennzeichnet, daß der niederohmige Ausgang des Verstärkers (A) an die Impedanz (Z_{S}) der Signalquelle (S₁...S_{N}) angepaßt ist.

4. Vorrichtung nach einem der Ansprüche 1 bis 3, dadurch gekennzeichnet, daß die Verteilerleitung (D₁...D_{N}) am Leitungsanfang eine Impedanzveränderungseinrichtung (M) umfaßt und sich an ihrem anderen Ende über eine Belastungsimpedanz (Z_{C}) gleich der durch die genannte Impedanzveränderungseinrichtung (M) eingeführten Impedanz schließt.

5. Vorrichtung nach einem der Ansprüche 1 bis 4, bei der die Träger-Leiterplatte (F) mehrere Verteilerleitungen (D₁...D_{N}) umfaßt, jede gespeist mit einem bestimmten zu verteilenden Signal (S₁...S_{N}), dadurch gekennzeichnet, daß jede Leiterplatte (C₁...Cₚ) ausgerüstet ist mit einem Schaltorgan mit mehreren Pfaden (RL), eingeschaltet zwischen den Verbinder (Q) und den hochohmigen Verstärker (A).

6. Vorrichtung nach Anspruch 5, dadurch gekennzeichnet, daß das Schaltorgan (RL) durch ein nicht-koaxiales Standard-Relais gebildet wird.

7. Vorrichtung nach Anspruch 6, dadurch gekennzeichnet, daß ein Überwachungs- und Vergleichsorgan (L) in den Steuerschaltkreis des Relais (RL) eingeschaltet ist, um eine den wirklichen Zustand der Erregerspule (BR₁...BR_{N}) des Relais (RL) betreffende Information und eine den angenommenen Zustand dieser Spule betreffende Information zu vergleichen und im Falle von Ungleichheit zwischen diesen beiden Informationen einen Alarm zu erzeugen.

8. Vorrichtung nach einem der Ansprüche 1 bis 7, dadurch gekennzeichnet, daß nicht-abstrahlende Vierpole (QR) in jede Verteilerleitung (D₁...D_{N}) eingeschaltet sind, zwischen den Anschlußsockeln (E₁...Eₚ).

9. Vorrichtung nach Anspruch 8, dadurch gekennzeichnet, daß die Vierpole (QR) vom Typ mit serieller Induktivität und paralleler Kapazität sind.

10. Vorrichtung nach Anspruch 8 oder 9, dadurch gekennzeichnet, daß die Belastungsimpedanz (Z_{C}) gebildet wird durch eine mit einem Widerstand in Reihe geschaltete Induktivität.

11. Vorrichtung nach Anspruch 6 oder 7 und einem der Ansprüche 8 bis 10, dadurch gekennzeichnet, daß jedes der Relais mit einem Ruhe-/Arbeitskontakt versehen ist, wobei der Ruhekontakt ermöglicht, eine Kapazität (Cₑ) mit der Schaltung zu verbinden, die der Gesamtstreukapazität des entsprechenden Verstärkers (A) und des entsprechenden, auf seinen Arbeitskontakt geschalteten Relais (RL) äquivalent ist.

## Claims

1. Device for distributing fast analogue signals to several users, **characterised in that** it comprises:
- a backplane type of board (F) on which is printed, in the form of tracks, at least one twin-wire distribution line (D₁...D_{N}), whose one end is fed by a source (S₁...S_{N}) of the signal to be distributed, and whose other end is terminated by a load impedance (Z_{C}) equal to the characteristic impedance of the line;
- printed circuit mounting sockets (E₁...Eₚ) attached to the printed circuit backplane (F) and deployed along the distribution line (D₁...D_{N}) ; and
- user printed circuit boards (C₁...Cₚ), each fitted with a connector (Q) capable of being plugged into one of the sockets (E₁...Eₚ) of the printed circuit backplane (F), each of these user boards (C₁...Cₚ) containing an amplifier (A) whose high-impedance input is connected to the distribution line (D₁...D_{N}) via its connector (Q) and the corresponding socket (E₁...Eₚ) and whose low-impedance output is connected to a connecting terminal (B_{S}) for a user (U₁...Uₚ).

2. Device according to Claim 1, **characterised in that** the high-impedance input of the amplifier (A) is connected to the distribution line (D₁...D_{N}) by means of a short printed track.

3. Device according to Claim 1 or 2, **characterised in that** the low-impedance output of the amplifier (A) is matched to the impedance (Z_{Z}) of the signal source (S₁...S_{N}).

4. Device according to any one of Claims 1 to 3, **characterised in that** the distribution line (D₁...D_{N}) is provided at the end of the line with an impedance changing device (M) and is terminated at its other end with a load impedance (Z_{C}) equal to the impedance set by said impedance changing device (M).

5. Device according to any one of Claims 1 to 4, in which the printed circuit backplane (F) contains several distribution lines (D₁...D_{N}), each connected by a specific signal (S₁...S_{N}) to be distributed, **characterised in that** each printed circuit card (C₁...Cₚ) is equipped with a multi-way switching device (RL) interposed between the connector (Q) and the high-input-impedance amplifier (A).

6. Device according to Claim 5, **characterised in that** the switching device (RL) is composed of a non-coaxial standard relay.

7. Device according to Claim 6, **characterised in that** a monitoring and comparison device (L) is inserted in the control circuit of the relay (RL) to compare a signal relating to the actual state of the energizing coil (BR₁...BR_{N}) of the relay (RL) and a signal relating to the assumed state of this coil, and to generate an alarm in case of disparity between these two signals.

8. Device according to any one of Claims 1 to 7, **characterised in that** loss-less four-terminal networks (QR) are inserted in each distribution line (D₁...D_{N}) between the connection sockets (E₁...Eₚ).

9. Device according to Claim 8, **characterised in that** the four-terminal networks (QR) are of the series inductance and parallel capacitance type.

10. Device according to Claim 8 or 9, **characterised in that** the load impedance (Z_{C}) is composed of an inductor in series with a resistor.

11. Device according to Claim 6 or 7, and any one of Claims 8 to 10, **characterised in that** each of the relays is equipped with a normally-closed/normally-open contact, the normally-closed contact enabling a capacitance (C_{C}) to be connected to the circuit, said capacitance being equivalent to the total stray capacitance of the corresponding amplifier (A) and of the corresponding relay (RL) which is switched at its normally-open contact.
